# FASCICULE DE BREVET EUROPEEN

(11) **EP 4 016 763 B1**
(45) Date de publication et mention de la délivrance du brevet: **19.07.2023**
(21) Numéro de dépôt: 21215743.2
(22) Date de dépôt: 17.12.2021
(51) Int. Cl.: H01S 5/12, H01S 5/20, H01S 5/042, H01S 5/34, H01S 5/10, H01S 5/22

(54) **LASER COMPRENANT UN MIROIR DE BRAGG DISTRIBUÉ ET PROCÉDÉ DE RÉALISATION**
LASER MIT EINEM VERTEILTEN BRAGG-SPIEGEL UND SEIN HERSTELLUNGSVERFAHREN
LASER COMPRISING A DISTRIBUTED BRAGG REFLECTOR AND METHOD FOR MANUFACTURING SAME

(30) Priorité: 18.12.2020 FR 2013658
(43) Date de publication de la demande: 22.06.2022
(73) Titulaire: Commissariat à l'Energie Atomique et aux Energies Alternatives, 75015 Paris (FR)
(72) Inventeur: REBOUD, Vincent, 38054 GRENOBLE Cedex 09 (FR); FOURNIER, Maryse, 38054 GRENOBLE Cedex 09 (FR); FEDELI, Jean-Marc, 38054 GRENOBLE Cedex 09 (FR)
(74) Mandataire: Hautier, Nicolas

(56) Documents cités:
- US-A1- 2002 141 467
- US-A1- 2008 199 131
- US-A1- 2011 101 250
- US-A1- 2015 333 482
- WANG Q C ET AL: "1.3[mu]m laterally coupled distributed feedback laser with a triangular prism etched facet", SPIE PROCEEDINGS; [PROCEEDINGS OF SPIE ISSN 0277-786X], SPIE, US, vol. 11023, 12 mars 2019 (2019-03-12), pages 110233Z-110233Z, XP060116376, DOI: 10.1117/12.2517896 ISBN: 978-1-5106-3673-6
- KAMP M ET AL: "Lateral coupling - a material independent way to complex coupled DFB lasers", OPTICAL MATERIALS, ELSEVIER SCIENCE PUBLISHERS B.V. AMSTERDAM, NL, vol. 17, no. 1-2, 1 juin 2001 (2001-06-01) , pages 19-25, XP027378151, ISSN: 0925-3467 [extrait le 2001-06-01]
- DRIDI K ET AL: "Narrow-linewidth and single-mode 1.55 m laterally-coupled distributed feedback laser fabricated by standard I-line stepper lithography", COMMUNICATIONS AND PHOTONICS CONFERENCE (ACP), 2012 ASIA, IEEE, 7 novembre 2012 (2012-11-07), pages 1-3, XP032389820, ISBN: 978-1-4673-6274-0
- APIRATIKUL PAVEEN ET AL: "GaInAsSb-AlGaAsSb laterally coupled distributed-feedback metamorphic laser grown on a GaAs substrate at 2", CLEO: 2013, THE OPTICAL SOCIETY, 9 juin 2013 (2013-06-09), pages 1-2, XP032602372, DOI: 10.1364/CLEO_SI.2013.CM2K.4
- VON EDLINGER M ET AL: "Widely-tunable interband cascade lasers for the mid-infrared", PROCEEDINGS OF SPIE, IEEE, US, vol. 9370, 15 janvier 2015 (2015-01-15), pages 93702A-93702A, XP060044830, DOI: 10.1117/12.2079926 ISBN: 978-1-62841-730-2

## Description

### DOMAINE TECHNIQUE

La présente invention concerne le domaine de l'optoélectronique. Elle peut être mise en oeuvre pour la réalisation de composants émetteurs de lumière, notamment dans le domaine du moyen infrarouge (MIR). Elle trouve pour application particulièrement avantageuse la réalisation de miroirs de Bragg distribués pour des sources laser à cascade quantique en technologie compatible CMOS. Un exemple d'application particulier concerne les capteurs environnementaux utilisant des sources MIR.

### ETAT DE LA TECHNIQUE

Un laser comprenant un réflecteur de Bragg distribué est appelé laser à rétroaction répartie DFB (pour « Distributed FeedBack » signifiant « rétroaction distribuée » ou « rétroaction répartie »).

Le laser peut être basé sur un principe d'amplification à cascade quantique. Un tel laser est alors dit LCQ (pour Laser à Cascade Quantique).

Un principe de fonctionnement du laser à cascade quantique est le suivant : la région active du laser est polarisée électriquement via des électrodes, de façon à injecter des électrons. Cette région active comprend typiquement une multitude de puits quantiques dans lesquels un électron va perdre successivement une partie de son énergie, en cascade, en émettant à chaque fois un photon d'énergie donnée. Ces photons forment le rayonnement lumineux de longueur d'onde λ.

Ce rayonnement lumineux se propage de façon guidée au sein de la cavité optique du laser. Cette cavité optique est typiquement bornée par des couches inférieures et supérieures dites LOC (acronyme de « Low Optical Confinement » signifiant confinement [par une couche de] bas indice optique), et au moins un réflecteur de Bragg. Les couches LOC permettent de mieux confiner le mode optique dans la région active.

Le réflecteur de Bragg distribué est un miroir permettant de réfléchir un rayonnement lumineux de longueur d'onde λ donnée avec une réflectivité R supérieure à 99%. Un tel miroir comprend typiquement des corrugations périodiques présentant des indices de réfraction différents. Une réflexion partielle du rayonnement lumineux se produit à chaque alternance d'indices. Pour un pas de réseau de l'ordre de Λ = m.λ/2n, n étant l'indice de réfraction effectif et m l'ordre du réseau, les réflexions partielles se combinent par interférences constructives, et les corrugations « distribuées » le long du réseau agissent comme un miroir de grande qualité.

Les réflecteurs ou miroirs de Bragg distribués sont donc particulièrement avantageux pour la fabrication de lasers monomodes présentant une largeur d'émission spectrale très étroite.

Parmi les nombreuses applications des systèmes optiques comprenant des lasers LCQ DFB, la détection d'éléments chimiques ou biologiques (CO2, CH4, NH3..., glucose ...) est particulièrement intéressante. La largeur spectrale très étroite des lasers LCQ DFB permet en effet d'augmenter avantageusement la sensibilité de détection.

Les performances de ces lasers dépendent notamment de la qualité des réflecteurs de Bragg distribués et de la qualité d'injection des électrons dans la région active.

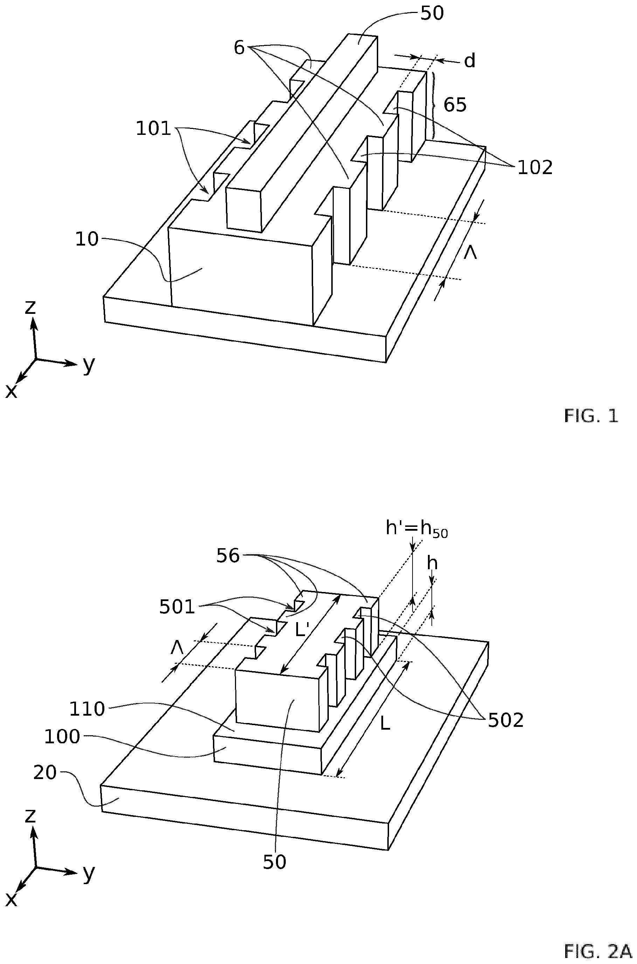

Le document US 2015333482 A1 divulgue une architecture de laser LCQ DFB destiné à émettre un rayonnement lumineux monochromatique selon une direction longitudinale x. Comme illustré schématiquement sur la figure 1, les éléments essentiels de cette architecture comprennent un empilement 10 selon z de couches à base de matériaux III-V, et un réflecteur de Bragg 65 formé par des corrugations 6 latérales périodiques de période Λ sur les flancs latéraux 101, 102 de l'empilement 10.

Cette architecture comprend en outre une électrode supérieure 50 disposée sur le sommet de l'empilement 10 de couches. Une telle architecture permet d'améliorer la dissipation thermique via l'électrode supérieure, tout en conservant une forte réflectivité via la structuration DFB latérale.

Les documents US 20110101250 A1, « 1.3 µm laterally coupled distributed feedback laser with a triangular prism etched facet, Wang Q.C et al., 5th Symposium on novel Optoelectronic Détection Technology and Application, SPIE vol. 11023 (2019) », « Widely tunable interband cascade lasers for the mid-infrared, Von Edlinger et al., quantum sensing and nanophotonic devices XII, SPIE vol. 9370 (2015) » divulguent également des architectures de laser DFB à corrugations latérales.

Il existe cependant un besoin consistant à améliorer encore les performances d'un laser à structuration DFB latérale.

Un objet de la présente invention est donc de proposer un laser à structuration DFB latérale présentant des performances améliorées.

Un autre objet de la présente invention est de proposer un procédé de fabrication d'un tel laser.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du laser peuvent s'appliquer mutatis mutandis au procédé, et réciproquement.

### RESUME

Pour atteindre cet objectif, selon un mode de réalisation on prévoit un laser comprenant un miroir de Bragg distribué.

Le laser est destiné à émettre un rayonnement lumineux selon une direction longitudinale x et comprend un guide d'onde formé au moins en partie dans un empilement de couches à base de matériaux III-V. Ce guide d'onde comprend au moins une région active de l'empilement, configurée pour émettre ledit rayonnement lumineux.

Le miroir comprend des corrugations latérales disposées périodiquement selon x selon une période Λ. Ces corrugations latérales sont portées par au moins un plan latéral xz défini par la direction longitudinale x et une première direction transverse z normale à la direction longitudinale x. Ces corrugations latérales présentent une dimension d selon une deuxième direction transverse y normale à la direction longitudinale x.

Le laser comprend en outre une électrode supérieure disposée sur le guide d'onde, selon la première direction transverse z.

Avantageusement, les corrugations latérales du miroir de Bragg sont situées au moins en partie au niveau de flancs latéraux de l'électrode supérieure, et uniquement sur lesdits flancs latéraux, lesdits flancs latéraux s'étendant parallèlement au plan latéral xz.

En particulier, les corrugations latérales ne s'étendent pas sur des flancs latéraux de la région active. La région active reste ainsi intacte sous l'électrode supérieure.

La région active d'un laser LCQ peut être décomposée en zones fonctionnelles distinctes : des zones d'émission de photons et des zones d'injection d'électrons. Structurellement, l'empilement de puits quantiques de la région active peut jouer le rôle d'un résonateur de Bragg, notamment au niveau des zones d'injection, pour les fonctions d'onde des électrons. Cela peut alors générer une bande interdite de faible amplitude entre les zones d'émission.

Dans le cadre du développement de la présente invention, il a été observé que la structuration DFB latérale de la région active selon l'art antérieur engendre des longueurs caractéristiques Λ/2 selon x dans la région active, pour chaque zone d'émission et chaque zone d'injection. Une telle dimension caractéristique est inférieure à la longueur de diffusion des électrons. Cela perturbe fortement l'injection des électrons, notamment au voisinage de la structuration DFB latérale. En particulier, les corrugations accroissent la surface développée des flancs latéraux de la région active. La passivation de ces flancs latéraux est imparfaite. La probabilité de recombinaisons non radiatives augmente donc, ceci d'autant plus que la largeur des corrugations est inférieure à la longueur de diffusion des électrons. Ces électrons ne participent donc pas à l'émission de lumière. L'efficacité d'injection est ainsi diminuée. Le seuil laser est augmenté. Par construction, il apparaît donc que la structuration DFB latérale de la région active rend l'injection des électrons inefficace.

Pour éviter de structurer latéralement la région active des lasers LCQ, la structuration DFB latérale est ici réalisée dans l'électrode supérieure d'injection. Cela permet d'améliorer l'injection des électrons dans la région active. Cela permet également de limiter significativement les pertes optiques du laser.

De façon surprenante, la structuration DFB latérale de l'électrode supérieure métallique permet d'obtenir une rétroaction optique efficace. Une telle structuration DFB latérale de l'électrode supérieure métallique permet en outre d'obtenir un bon contrôle du champ lointain associé au rayonnement lumineux émis par le laser LCQ.

Le réflecteur de Bragg structuré latéralement dans l'électrode supérieure permet ainsi d'obtenir les performances optiques nécessaires au LCQ DFB tout en assurant une injection électrique améliorée. Les performances du laser sont ainsi améliorées.

Selon un autre aspect on prévoit un procédé de formation d'un laser comprenant un miroir de Bragg distribué. Ce procédé comprend :
- Une fourniture d'un empilement de couches à base de matériaux III-V comprenant au moins une région active destinée à émettre un rayonnement lumineux,
- Une formation d'un motif de guide d'onde dans l'empilement de couches, ledit motif de guide d'onde présentant une longueur L selon une direction longitudinale x, une hauteur h selon une première direction transverse z et une largeur w selon une deuxième direction transverse y, les première et deuxième directions transverses z, y étant normales à la direction longitudinale x,
- Un premier dépôt d'une première couche métallique sur un sommet du motif de guide d'onde,
- Une structuration de ladite première couche métallique de sorte à former une électrode supérieure présentant des flancs latéraux s'étendant parallèlement à un plan latéral xz défini par la direction longitudinale x et la première direction transverse z.

Avantageusement, ladite structuration est configurée pour former des corrugations latérales au niveau desdits flancs latéraux de l'électrode supérieure, et uniquement sur lesdits flancs latéraux, lesdites corrugations latérales étant périodiques de période Λ selon la direction longitudinale x et s'étendant principalement selon la première direction transverse z, et présentant une dimension d selon la deuxième direction transverse y, de sorte que ladite électrode supérieure forme au moins en partie le miroir de Bragg distribué.

Ce procédé permet typiquement de réaliser des lasers tels que décrits plus hauts et présentant des performances améliorées. Ce procédé est en outre typiquement basé sur une filière technologique silicium avantageusement compatible avec une chaine de fabrication dite CMOS (fabrication de transistors métal-oxyde-semiconducteur complémentaires).

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre schématiquement un laser DFB à structuration latérale comprenant une électrode supérieure selon l'art antérieur.
La figure 2A illustre schématiquement un laser DFB à structuration latérale selon un premier mode de réalisation de la présente invention.
La figure 2B illustre schématiquement un laser DFB à structuration latérale selon un deuxième mode de réalisation de la présente invention.
La figure 2C illustre schématiquement un laser DFB à structuration latérale selon un troisième mode de réalisation non couvert par la présente invention.
La figure 3 illustre la distribution en champ lointain de l'intensité émise par un laser DFB selon un mode de réalisation de la présente invention.
La figure 4 illustre la réflectivité d'un réflecteur de Bragg distribué à structuration latérale pour différentes hauteurs d'empilement, selon un mode de réalisation de la présente invention.
Les figures 5A à 5P illustrent schématiquement en coupe transverse des étapes d'un procédé de fabrication d'un laser DFB à structuration latérale selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches, et les dimensions des corrugations et des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon l'invention, les corrugations latérales du miroir de Bragg s'étendent uniquement sur les flancs latéraux de l'électrode supérieure. Aucune couche de l'empilement de couches à base de matériaux III-V ne participe ainsi au DFB latéral.

Selon un exemple, le guide d'onde comprend une couche supérieure à base d'InGaAs présentant une concentration de dopants supérieure ou égale à 1 × 10¹⁹cm⁻³. Les corrugations latérales du miroir de Bragg s'étendent depuis les flancs latéraux de l'électrode supérieure jusqu'à des flancs latéraux de ladite couche supérieure. L'injection électrique dans la région active n'est avantageusement pas perturbée lorsque la structuration latérale du DFB s'étend jusqu'à la couche supérieure de l'empilement.

Selon un exemple, le guide d'onde présente une hauteur h inférieure ou égale à 6 µm. Cela permet d'améliorer l'efficacité de réflexion optique du réflecteur de Bragg latéral formé au niveau de l'électrode supérieure métallique. Cette valeur de hauteur h peut être optimisée en fonction de la longueur d'onde d'émission, de la largeur de guide et de l'empilement de couches à base de matériaux III-V.

Selon un exemple, les corrugations latérales du miroir de Bragg présentent une dimension en hauteur h' supérieure ou égale à 1 µm.

Selon un exemple, la période Λ et la dimension d sont choisies telles que 0,2 ≤ d/Λ ≤ 2, et de préférence 0,4 ≤ d/Λ ≤ 0,8.

Selon un exemple, le laser est un laser à cascade quantique.

Selon un exemple, le procédé comprend en outre une structuration d'une couche supérieure à base d'InGaAs du guide d'onde, de sorte que les corrugations latérales du miroir de Bragg s'étendent depuis les flancs latéraux de l'électrode supérieure jusqu'à des flancs latéraux de ladite couche supérieure. Cette structuration de la couche supérieure à base d'InGaAs peut être assistée par la présence d'une couche d'arrêt au sein de l'empilement, par exemple sous ou au sein de ladite couche supérieure. Une telle couche d'arrêt permet de bien contrôler la hauteur h₁₆ suivant laquelle s'étendent les corrugations latérales sur les flancs latéraux de ladite couche supérieure à base d'InGaAs.

Selon un exemple, les corrugations latérales du miroir de Bragg s'étendent sur les flancs latéraux de ladite couche supérieure, sur une hauteur h₁₆ supérieure ou égale à 50 nm.

Selon un exemple, les corrugations latérales du miroir de Bragg présentent une dimension en hauteur h₁₆ au niveau des flancs latéraux de ladite couche supérieure, la dimension en hauteur h₁₆ étant supérieure ou égale à 50 nm.

Selon un exemple, la structuration de la couche supérieure à base d'InGaAs est effectuée avant la structuration de la première couche métallique et la structuration de la première couche métallique est alignée vis-à-vis de la structuration de la couche supérieure à base d'InGaAs.

Selon un exemple, la structuration de la couche supérieure à base d'InGaAs est effectuée après la structuration de la première couche métallique et la première couche métallique structurée est utilisée comme masque pour la structuration de la couche supérieure à base d'InGaAs. Cela permet d'obtenir un bon alignement des corrugations latérales le long des flancs de l'électrode supérieure et de la couche supérieure.

Selon un exemple, le procédé comprend en outre, après structuration de la première couche métallique, un deuxième dépôt d'une deuxième couche métallique sur l'électrode supérieure. Cela permet d'augmenter l'épaisseur de l'électrode supérieure, tout en bénéficiant d'une bonne résolution pour la définition des corrugations latérales du DFB. Une électrode supérieure suffisamment épaisse permet de diminuer la résistance électrique d'accès et d'évacuer la chaleur en fonctionnement.

Selon un exemple, le deuxième dépôt est réalisé par dépôt électrochimique.

Selon un exemple, le procédé comprend en outre une structuration complémentaire de la deuxième couche métallique, de façon à former un motif d'électrode complémentaire sur l'électrode supérieure.

Selon un exemple, ladite structuration complémentaire est configurée de sorte à prolonger les corrugations latérales de l'électrode supérieure sur des flancs latéraux du motif d'électrode complémentaire.

Selon un exemple, ladite structuration complémentaire est configurée de sorte à ce que le motif d'électrode complémentaire présente des flancs latéraux parallèles au plan latéral xz et exempts de corrugations latérales.

Sauf incompatibilité, il est entendu que le miroir, le procédé de fabrication, et le laser peuvent comprendre, *mutatis mutandis,* l'ensemble des caractéristiques optionnelles ci-dessus.

Dans le cadre de la présente invention, les locutions « miroir de Bragg », « réseau de Bragg » ou « réflecteur de Bragg distribué » ou encore « DFB (Distributed FeedBack) » sont employées en synonymes. Le miroir de Bragg est ici configuré pour être utilisé comme réflecteur pour un guide d'onde. Il comprend une alternance périodique de matériaux d'indices de réfraction différents. Cette alternance induit une variation périodique de l'indice de réfraction effectif dans le guide d'onde. Une telle alternance est reproduite au moins deux fois dans le cadre d'un miroir de Bragg selon la présente invention.

Cette alternance est typiquement produite par des corrugations latérales. Les corrugations latérales désignent des éléments en saillie vis-à-vis d'un plan latéral. Elles peuvent présenter différents profils en projection dans un plan xy, par exemple et de façon non limitative : un profil en créneau tel qu'illustré dans les dessins d'accompagnement, un profil sinusoïdal ou triangulaire.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Les gammes de dopage associées aux différents types de dopage indiqués dans la présente demande sont les suivantes :
- dopage p++ ou n++ : supérieur à 1 × 10²⁰cm⁻³
- dopage p+ ou n+ : 1 × 10¹⁸ cm⁻³ à 9 × 10¹⁹ cm⁻³
- dopage p ou n : 1 × 10¹⁷ cm⁻³ à 1 × 10¹⁸ cm⁻³
- dopage intrinsèque : 1.10¹⁵ cm⁻³ à 1.10¹⁷ cm⁻³

Les exemples de réalisation décrits dans la suite indiquent un dopage de type n. D'autres modes de réalisation, dans lesquels un dopage de type p est réalisé, peuvent également être envisagés. Ainsi, des lasers QCL pour lesquels les porteurs de charge sont des trous peuvent également être réalisés selon la présente invention.

Le domaine du moyen infrarouge (MIR) comprend typiquement des longueurs d'onde λ entre 3 µm et 12 µm. Un exemple de mise en oeuvre du procédé est donné pour la réalisation d'un laser LCQ DFB émettant à une longueur d'onde de 7,4 µm. Le miroir de Bragg présente typiquement un pic de réflectivité centré sur la longueur d'onde λ.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy. Le terme « latéral » se réfère à un plan xz. Ainsi, des corrugations latérales sont portées par un plan xz. Une structuration latérale est effectuée au niveau d'un plan xz.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Un premier exemple de laser selon l'invention est illustré à la figure 2A. Dans cet exemple, un guide d'onde 100 à base de matériaux III-V est formé sur un substrat 20. Ce guide d'onde 100 comprend au moins une région active destinée à émettre un rayonnement lumineux de longueur d'onde λ. Il est surmonté par une électrode supérieure 50 structurée en DFB latéral. L'ensemble forme ainsi un laser LCQ DFB.

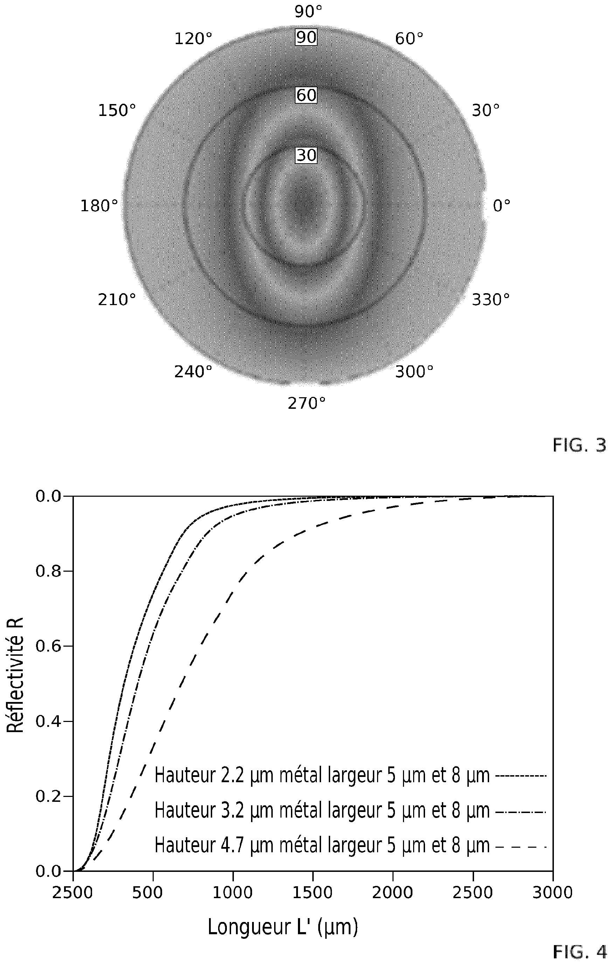

Le guide d'onde 100 présente typiquement une longueur L selon x, une largeur w selon y et une hauteur h selon z. La longueur L est typiquement de l'ordre de quelques centaines de microns à quelques millimètres, par exemple comprise entre 500 µm et 4 mm, voire 6 mm. On choisira par exemple de préférence L=1 mm ou L=2 mm. La largeur w est de l'ordre de quelques microns, par exemple comprise entre 4 µm et 10 µm, par exemple w=8 µm. La hauteur h est typiquement de l'ordre de quelques microns, par exemple comprise entre 1 µm et 5 µm, par exemple w=3,2 µm. La hauteur h est de préférence inférieure à 4 µm. Cela permet de conserver une bonne efficacité du DFB latéral de l'électrode supérieure 50 pour la réflexion optique. En effet, pour des hauteurs h de guide d'onde supérieures à 4 µm environ, le mode optique d'un rayonnement de longueur d'onde λ=7,4 µm est très confiné dans le guide d'onde. Cela réduit l'efficacité du DFB métallique. Il faut donc augmenter la longueur L' totale du DFB métallique latéral pour obtenir une réflexion optique suffisante pour le laser LCQ, comme illustré à la figure 4 et détaillé par la suite. Au contraire, pour des hauteurs h de guide d'onde inférieures à 4 µm environ, le mode optique présente un bon couplage avec le réseau DFB.

Le guide d'onde 100 peut être un guide d'onde en ruban présentant une section rectangulaire, ou un guide d'onde en arête présentant une section en T inversé. Dans le cas d'un guide d'onde en arête, la partie supérieure du guide se présente typiquement sous forme d'un mésa s'étendant longitudinalement, de longueur L, de largeur wₘ < w et de hauteur hₘ < h. Le sommet du guide d'onde est ici le sommet du mésa. D'autres géométries de guide d'onde sont également possibles.

Le guide d'onde 100 peut être formé à partir d'une vignette comprenant un empilement 10 de couches à base de matériaux III-V, reportée sur un substrat à base de silicium. Ce report peut typiquement se faire par collage moléculaire. La vignette peut se présenter sous forme d'un substrat InP de deux pouces sur lequel est formé l'empilement 10. Le substrat 20 comprend ainsi typiquement une partie en silicium et éventuellement une partie en InP et/ou quelques couches de l'empilement 10. Le substrat InP peut être aminci ou retiré partiellement ou en totalité lors du report, avant ou après collage. Le guide d'onde 100 est structuré dans les couches supérieures de l'empilement 10.

L'empilement 10 comprend typiquement une pluralité de couches destinées à l'injection des électrons, à l'émission du rayonnement lumineux, au guidage du rayonnement lumineux.

Selon une possibilité, l'empilement 10 peut comprendre, depuis l'interface de collage jusqu'à la surface supérieure 110 de l'empilement selon z :
- une couche à base d'InP dopée n+ ou n++, présentant une épaisseur comprise entre 1,5 µm et 5 µm voire 6 µm,
- Une couche d'InGaAs n++ de 100 nm à 300 nm peut être avantageusement intercalée au sein de la couche d'InP n+ ou n++ mentionnée ci-dessus. Cette couche d'InGaAs n++ se trouve de préférence à une profondeur comprise entre 1 µm et 3 µm, idéalement entre 1,5 µm et 2 µm, de la face supérieure de la couche d'InP n+ ou n++. Cette couche d'InGaAs dopée présente typiquement un niveau de dopage supérieur d'au moins un facteur 10 au niveau de dopage de la couche InP n+ ou n++ mentionnée ci-dessus.

- une couche à base d'InGaAs dite LOC, présentant une épaisseur comprise entre 20 nm et 200 nm,
- une région active présentant une épaisseur comprise entre 1,5 µm et 4 µm,
- une couche à base d'InGaAs dite LOC, présentant une épaisseur comprise entre 20 nm et 200 nm,
- une couche à base d'InP, présentant une épaisseur comprise entre 200 nm et 3 µm, et un faible niveau de dopage,
- une couche à base d'InGaAs dopée n+ ou n++, présentant une épaisseur comprise entre 20 nm et 300 nm. Cette couche d'InGaAs dopée présente typiquement un niveau de dopage supérieur d'au moins un facteur 10 au niveau de dopage de la couche InP sous-jacente.

Les couches dopées n+ ou n++ participent typiquement à l'injection des électrons au sein de la région active. Les couches LOC permettent typiquement de confiner le rayonnement lumineux au niveau de la région active. Elles présentent typiquement un faible indice de réfraction, par exemple de l'ordre de 3,18 pour une longueur d'onde λ de l'ordre de 7,4 µm, et sont appelées couches de guidage. Le faible niveau de dopage de la couche InP permet de limiter les pertes optiques. L'épaisseur relativement grande de cette couche InP permet une répartition homogène de l'injection des électrons dans toute la région active.

La région active comprend typiquement une multitude de puits quantiques dans lesquels les électrons vont transiter en cascade, en émettant un rayonnement lumineux. Selon une possibilité, la région active peut comprendre des couches d'InGaAs et d'AllnAs alternées. Le lecteur peut se référer au document « Carras, M. et al. Top grating index-coupled distributed feedback quantum cascade lasers. Appl. Phys. Lett. 93, 011109 (2008) » pour la conception de la région active, en particulier pour le choix des hétérostructures d'InGaAs/d'AIInAs, le nombre de périodes et/ou de puits quantiques, l'architecture de super-réseau résonnant.

L'électrode supérieure 50 surmonte le sommet du guide d'onde 100. Elle est à base de matériau métallique. Elle est par exemple constituée d'une ou plusieurs couches à base d'or, et/ou de titane, et/ou de nitrure de titane, et/ou d'alliage aluminium-cuivre, et/ou de tungstène. Elle présente une hauteur h₅₀ selon z, de préférence comprise entre 1 µm et 3 µm. Elle présente également des flancs latéraux 501, 502 parallèles au plan xz. Avantageusement, cette électrode est structurée au niveau de ses flancs latéraux 501, 502 de façon à former un réflecteur de Bragg distribué ou DFB latéral. Elle présente ainsi typiquement des corrugations 56 sur les flancs latéraux 501, 502. Ces corrugations 56 sont réparties régulièrement selon x selon une période Λ. La période Λ est de préférence choisie telle que Λ = m.λ/2n, λ étant la longueur d'onde du rayonnement lumineux, n étant l'indice de réfraction effectif du mode optique de propagation du rayonnement lumineux, et m l'ordre du réseau du réflecteur de Bragg. L'électrode supérieure 50 et/ou l'empilement 10 peuvent être encapsulés par une couche d'encapsulation, typiquement à base de matériau diélectrique.

Les corrugations 56 sont disposées de part et d'autre des flancs 501, 502, en vis-à-vis selon y. Elles présentent chacune une dimension d selon y et une dimension l selon x. Dans cet exemple, les corrugations 56 présentent une hauteur h' = h₅₀, de sorte qu'elles s'étendent sur toute la hauteur de l'électrode 50. La dimension d est de l'ordre de quelques microns, par exemple 1,5 µm. La dimension l est par exemple égale à une demi-période Λ/2. La largeur hors tout de l'électrode 50, incluant les corrugations 56 est de préférence égale à la largeur du sommet du guide d'onde 100, w ou wₘ. Ainsi, l'électrode 50 peut présenter une alternance de parties étroites de largeur 5 µm et de parties larges, au niveau des corrugations 56, de largeur 8 µm par exemple. La modulation de largeur selon y est choisie telle que d/Λ < 1. Selon un exemple, la période Λ et la dimension d sont choisies telles que 0,2 ≤ d/Λ ≤ 2, et de préférence telles que 0,4 ≤ d/Λ ≤ 0,8, par exemple d/Λ = 0,625. Cela permet d'obtenir un bon compromis entre la force de couplage du réseau de Bragg et l'efficacité du laser LCQ. L'ensemble des corrugations latérales forment le DFB latéral de longueur L' et de hauteur h'.

Le dimensionnement du laser peut être effectué de la façon suivante :
- Le band-gap effectif de la région active du laser LCQ peut être mesuré par photoluminescence, pour déterminer précisément la longueur d'onde λ d'émission de la région active.
- L'indice effectif du mode optique fondamental du laser peut être évalué expérimentalement en réalisant séparément des cavités Fabry Pérot à partir de l'empilement de couches destiné à former le laser LCQ. Alternativement, il peut être modélisé à partir des propriétés des matériaux des couches de l'empilement.
- La période Λ du réseau DFB peut ensuite être calculée pour la longueur d'onde λ.
- Le confinement du mode optique au niveau de la région active du LCQ peut être évalué numériquement, par exemple par le logiciel Nextnano^{®}. Pour une longueur d'onde λ = 7,4 µm, on choisira typiquement un recouvrement en puissance de l'ordre de 0,70. Ainsi, pour une épaisseur d'InP de 1,2 µm au-dessus de la région active, le recouvrement est de préférence environ égal à 0.68 pour une largeur w de guide d'onde de 6 µm, et environ égal à 0,70 pour une largeur w de guide d'onde de 8 µm. Cela permet au mode optique de « voir » les bords du guide d'onde, et donc de coupler avec le DFB latéral de l'électrode supérieure. Pour des valeurs de recouvrement supérieures à 0,71, qui correspondent par exemple à des largeurs de guide d'onde supérieures à 10 µm, la structuration latérale devient moins efficace, et la longueur du laser doit être augmentée. Ces valeurs peuvent être ajustées en fonction de la nature et des épaisseurs des couches de l'empilement.
- La dimension d de retrait latéral pour chaque corrugation, et la hauteur des corrugations peuvent ensuite être fixées de façon à obtenir une réflectivité du DFB supérieure ou égale à 95%. De façon générale, la force de couplage avec le réseau de Bragg augmente en augmentant la dimension d des corrugations, jusqu'à un maximum au-delà duquel la force de couplage reste environ constante. Le calcul de réflectivité se fait typiquement à partir du seuil laser, et n'inclut pas les pertes optiques éventuelles en-dessous du seuil laser. La diminution des pertes optiques diminue le seuil laser.

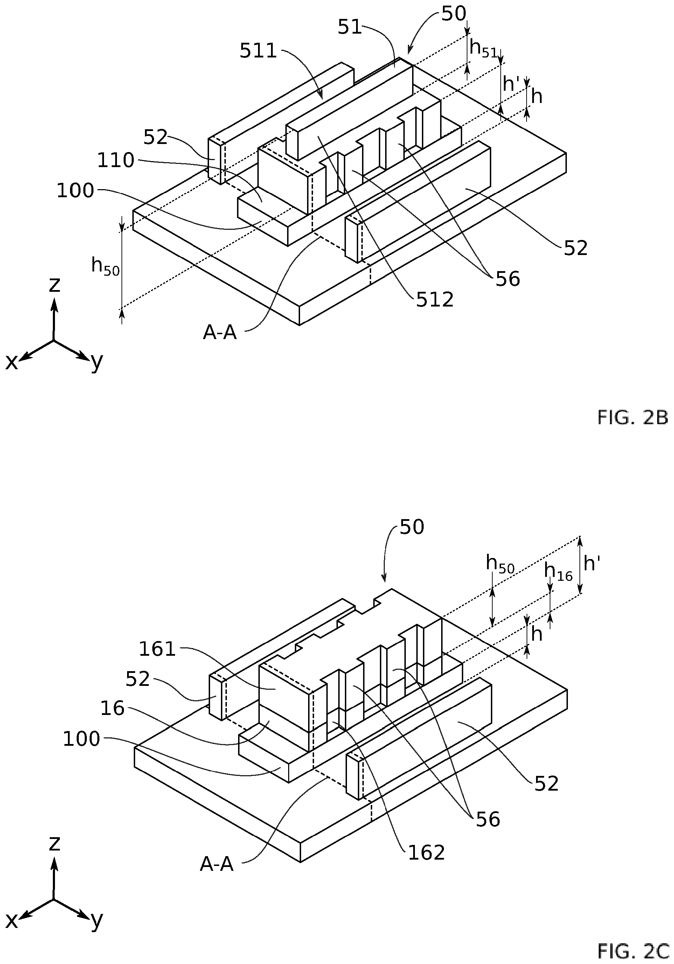

Un autre mode de réalisation de l'électrode supérieure 50 et du DFB est illustré à la figure 2B. Dans ce mode de réalisation, les corrugations 56 latérales de l'électrode 50 ne s'étendent pas sur toute la hauteur h₅₀ de l'électrode 50, de sorte que h' < h₅₀. La partie supérieure 51 de l'électrode 50 présente des flancs latéraux 511, 512 sensiblement plans et parallèles au plan xz. Cette partie supérieure 51 peut présenter une hauteur h₅₁ de l'ordre de 1 µm à 2 µm par exemple. Cela permet d'augmenter la hauteur totale h₅₀ de l'électrode 50. Cela rend l'électrode 50 plus robuste pour le contact électrique avec des connexions électriques. Cela permet également d'améliorer la dissipation thermique via l'électrode 50. Cela permet également de diminuer la résistance électrique de contact au niveau de l'électrode 50. Dans ce mode de réalisation, on choisira typiquement une hauteur de corrugation h' = h₅₀ - h₅₁ supérieure ou égale à 1 µm, et/ou un rapport d'aspect h₅₀/h₅₁ ≥ 1. Par exemple, pour une électrode de hauteur h₅₀ = 2 µm, le rapport d'aspect h₅₀/h₅₁ est de préférence supérieur ou égal à 1. Pour une électrode de hauteur h₅₀ = 3 µm, le rapport d'aspect h₅₀/h₅₁ est de préférence supérieur ou égal à 2. La réflectivité du DFB peut être sensiblement la même que dans le cas de corrugations s'étendant sur toute la hauteur h₅₀ de l'électrode, dans la mesure où le mode optique ne « voit » pas la partie supérieure 51 de l'électrode 50. La largeur hors tout de l'électrode 50, incluant les corrugations latérales 56, peut être sensiblement égale à la largeur w du guide d'onde 100. Ainsi, les corrugations latérales 56 présentent des faces latérales à l'aplomb des flancs latéraux 101, 102 du guide d'onde 100.

Un autre mode de réalisation de l'électrode supérieure 50 et du DFB est illustré à la figure 2C. Ce mode de réalisation n'est pas couvert par l'invention. Dans ce mode de réalisation, les corrugations 56 latérales du DFB s'étendent sur une hauteur h' > hso. Ainsi, les corrugations 56 s'étendent depuis les flancs latéraux 501, 502 de l'électrode 50 jusque sur les flancs latéraux 161, 162 de la couche supérieure 16 de l'empilement 10. Cette couche supérieure 16 est typiquement une couche à base d'InGaAs dopée n+ ou n++, présentant une épaisseur comprise entre 20 nm et 100 nm. Dans ce mode de réalisation, les corrugations 56 du DFB sont en partie réalisées dans l'électrode 50 et dans la couche supérieure 16 de l'empilement. Cela permet de rapprocher le DFB de la région active, sans pour autant perturber significativement l'injection des électrons. La hauteur h₁₆ de la partie des corrugations réalisées dans la couche 16 peut être inférieure ou égale à l'épaisseur de la couche 16. Les parties des corrugations 56 réalisées dans la couche 16 sont sensiblement à l'aplomb des parties des corrugations réalisées dans l'électrode 50. La hauteur totale des corrugations 56 est ici h' = h₅₀ + h₁₆. Ce mode de réalisation peut être combiné avec le précédent de sorte que l'électrode 50 comprennent une partie supérieure 51 exempte de corrugations. Selon une possibilité, les corrugations 56 s'étendent depuis les flancs latéraux 501, 502 de l'électrode 50 jusque sur les flancs latéraux de la couche 15 de l'empilement 10. Dans tous les cas, les corrugations 56 ne s'étendent pas au niveau des flancs latéraux de la région active 13.

Ces modes de réalisation de DFB latéraux au moins en partie au niveau de l'électrode 50 ont pour avantage de limiter les pertes optiques sur les flancs du guide d'onde 100, et d'éviter une perturbation de l'injection des électrons dans la région active.

Ce type de DFB latéraux permet en outre d'éviter une perturbation du champ lointain du rayonnement lumineux émis par la région active. Comme illustré à la figure 3, la distribution en champ lointain de l'intensité du rayonnement lumineux n'est pas significativement modifiée par la présence du DFB latéral au-dessus du guide d'onde. Cela permet un bon contrôle du rayonnement lumineux en champ lointain. En particulier, le fait que les corrugations latérales ne s'étendent pas jusqu'à la région active diminue la divergence du faisceau formé par le rayonnement lumineux. La divergence diminue d'autant plus que la hauteur h₁₆ est petite, voire nulle. Le fait que l'électrode 50 participe au réseau DFB permet avantageusement de réduire la hauteur des corrugations latérales dans l'empilement de couches III-V. Le faisceau est donc moins divergent dans un tel guide, toutes choses étant égales par ailleurs, que dans un guide selon l'art antérieur.

La figure 4 illustre un calcul de réflectivité R effectué pour des DFB latéraux métalliques présentant une modulation de largeur entre 5 µm et 8 µm en alternance, en fonction de leur longueur L'. Les courbes de réflectivité R(L') sont tracées pour différentes hauteurs h de guides d'onde 100.

Le ratio d/Λ est ici égal à 0,625. La largeur de guide d'onde est de 8 µm. Pour obtenir une réflectivité supérieure ou égale à 95%, il apparaît que la longueur L' de DFB nécessaire diminue lorsque la hauteur h de guide diminue. Ainsi, on choisira de préférence une hauteur h de guide d'onde inférieure à 4 µm. Cela permet de dimensionner des DFB métallique latéraux de longueur L' raisonnable, typiquement inférieure à 1,5 mm. De telles dimensions de DFB sont parfaitement compatibles avec les lasers LCQ cités plus haut.

Le laser LCQ selon la présente invention, comprenant un DFB latéral métallique formé au moins en partie dans l'électrode supérieure, sans corrugations latérales au niveau des flancs de la région active, peut donc avantageusement être intégré dans un capteur environnemental fonctionnant dans le moyen infrarouge.

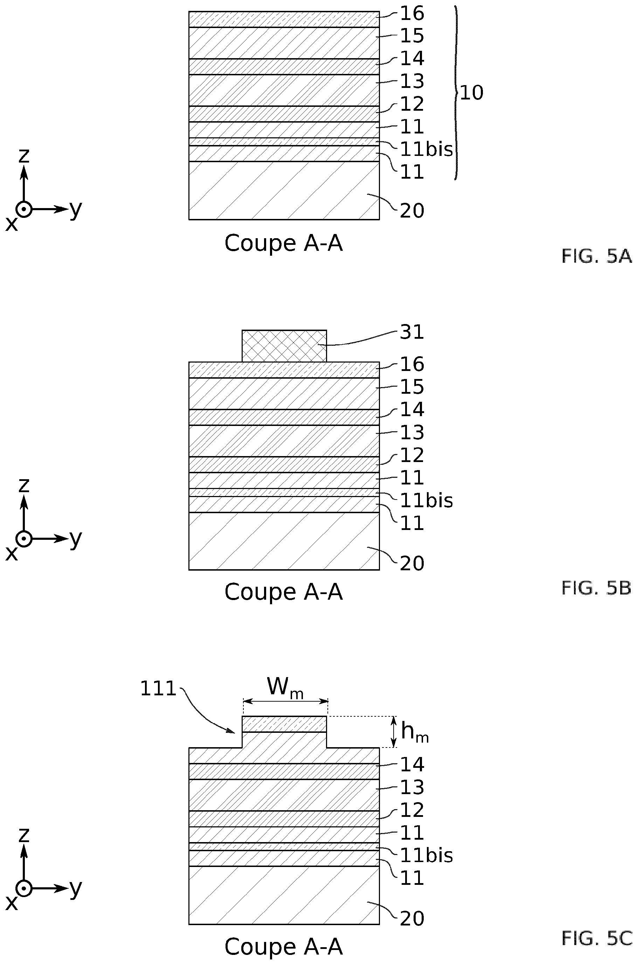

Les figures 5A à 5P illustrent un mode de réalisation d'un procédé de réalisation d'un tel laser.

Un empilement 10 de couches 11, 12, 13, 14, 15, 16 portées par un substrat 20 est d'abord fourni (figure 5A). Comme décrit précédemment, le substrat 20 peut être en silicium. L'empilement 10 comprend des couches à base de matériaux III-V, notamment :
- une couche 11 à base d'InP dopée n+ ou n++, présentant une épaisseur comprise entre 1,5 µm et 5 µm,
- une couche 11 bis à base d'InGaAs dopée n+ ou n++, présentant une épaisseur comprise entre 100 nm et 300 nm peut être avantageusement intercalée au sein de la couche 11. Cela permet d'améliorer l'injection électrique. Cette couche 11 bis peut être utilisée pour contacter l'électrode inférieure.
- une couche 12 à base d'InGaAs dite LOC, présentant une épaisseur comprise entre 20 nm et 200 nm,
- une région active 13 comprenant des puits quantiques et présentant une épaisseur comprise entre 1,5 µm et 4 µm,
- une couche 14 à base d'InGaAs dite LOC, présentant une épaisseur comprise entre 20 nm et 200 nm,
- une couche 15 à base d'InP, présentant une épaisseur comprise entre1 µm et 3 µm,
- une couche 16 à base d'InGaAs dopée n+ ou n++, présentant une épaisseur comprise entre 20 nm et 100 nm.

Dans cet exemple de réalisation, le guide d'onde formé est un guide en arête comprenant une structure supérieure en mésa. Ainsi, comme illustré aux figures 5B, 5C, une première lithographie/gravure uniquement optionnelle peut être effectuée de façon à former cette structure supérieure en mésa. La figure 5B illustre la formation d'un masque 31 de lithographie à base de résine photosensible permettant de définir la structure en mésa de largeur wₘ. La figure 5C illustre la gravure des couches 16 et 15 sur une profondeur hₘ, avec arrêt dans la couche 15 d'InP. Le masque 31 en résine est ensuite retiré et la structure 111 en mésa de largeur wₘ et de hauteur hₘ est formée (figure 5C).

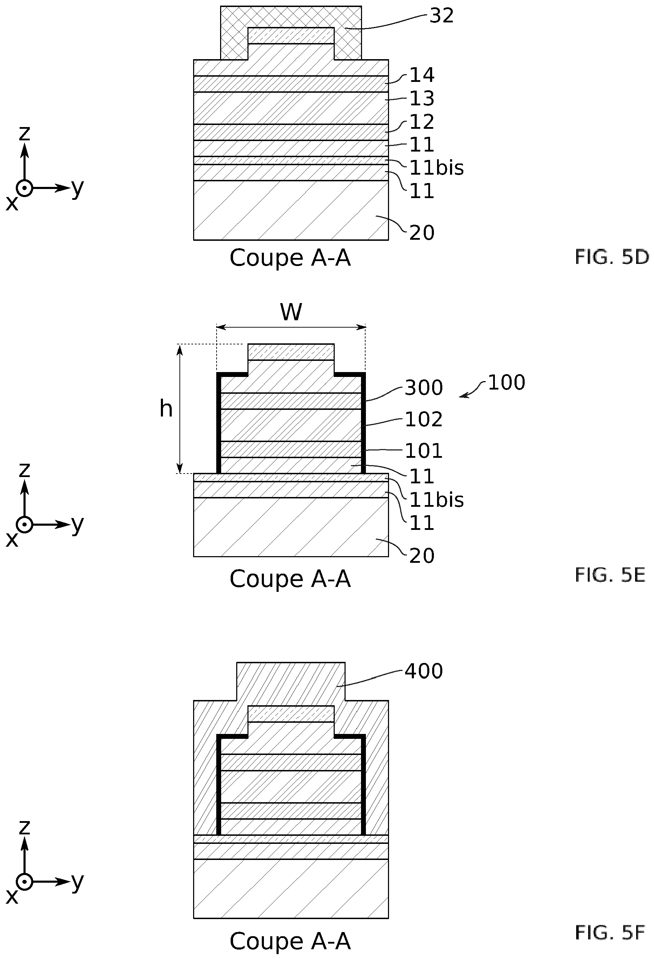

Les figures 5D, 5E illustrent la formation d'un motif de laser dans l'empilement 10 par lithographie/gravure. La figure 5D illustre la formation d'un masque 32 de lithographie à base de résine photosensible, éventuellement sur la structure 111 en mésa, permettant de définir le motif de laser de largeur w sous forme de guide d'onde 100, éventuellement en arête. La figure 5E illustre la gravure des couches 15, 14, 13, 12, 11 et 11 bis sur une profondeur h - hₘ, avec arrêt dans la couche 11 bis d'InGaAs dopée. Une telle gravure est connue et peut se faire par gravure sèche anisotrope selon z, par exemple par plasma à couplage inductif ICP (Inductively Coupled Plasma). La couche 11 bis en InGaAs peut être utilisée pour la détection de fin de gravure encore appelée détection de fin d'attaque (DFA).

Après retrait du masque 32, une fine couche 300 de passivation, typiquement en SiN d'épaisseur 300 nm environ, est déposée sur les flancs 101, 102 du guide d'onde 100 (figure 5E). Cette couche 300 de passivation est ouverte par lithographie/gravure au niveau de la couche 11 d'InP dopée, de manière à permettre la formation de l'électrode inférieure, et au niveau de la structure en mésa, de manière à permettre la formation de l'électrode supérieure.

La figure 5F illustre le dépôt d'une couche métallique 400 destinée à former les électrodes inférieure et supérieure. Cette couche métallique 400 peut comprendre différentes sous-couches, par exemple des couches d'accroche en Ti/TiN et une couche épaisse d'or ou d'alliage AlCu et/ou de tungstène. Cette couche métallique 400 présente de préférence une épaisseur de l'ordre de 1 µm.

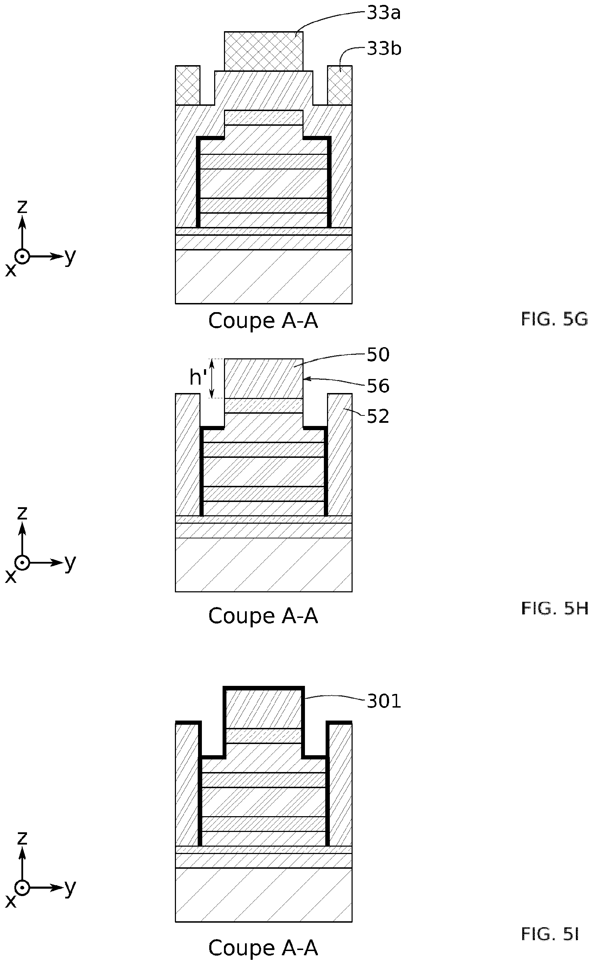

La figure 5G illustre la formation et la structuration par lithographie d'un masque 33a, 33b à base de résine. Ce masque 33a, 33b est destiné à définir les électrodes inférieure et supérieure. Le masque 33a est structuré latéralement, typiquement par lithographie UV profond, de façon à définir un motif de corrugations latérales au-dessus de la couche métallique 400.

La figure 5H illustre la gravure des zones exposées de la couche métallique 400, de façon à former les électrodes supérieure 50 et inférieure 52. Lors de la gravure, le motif de corrugations latérales est transféré dans l'électrode supérieure 50 de façon à former le DFB. Cette gravure est anisotrope selon z. Elle est configurée pour s'arrêter sur les couches exposées de l'empilement 10. Ainsi, la gravure des corrugations latérales 56 du DFB latéral de l'électrode supérieure 50 est arrêtée sur la couche 16. La gravure de la couche métallique 400 entre les masques 33a, 33b est typiquement arrêtée sur la couche de SiN 300. A ce stade, les corrugations 56 latérales de hauteur h' s'étendent sur toute la hauteur de l'électrode supérieure 50. Le dispositif illustré en figure 2A, comprenant un DFB latéral purement métallique, est ainsi réalisé.

Selon une variante, ce DFB latéral métallique est utilisé comme masque pour graver une partie des couches supérieures de l'empilement 10, par exemple la couche supérieure 16. La formation des corrugations 56 se poursuit ainsi dans la couche supérieure 16. La couche 15 en InP peut être utilisée pour la détection de fin de gravure ou DFA. La partie en matériau III-V des corrugations 56 est ainsi « auto-alignée » avec la partie métallique des corrugations 56. Cette variante permet de former le dispositif illustré en figure 2C, comprenant un DFB latéral mixte métal et InGaAs.

Le procédé peut être poursuivi pour épaissir les électrodes par recharge ou dépôts successifs de métal.

La figure 5I illustre une étape préliminaire de dépôt d'une couche 301 conforme de SiN, par exemple par dépôt chimique en phase vapeur basse pression LPCVD (acronyme de Low Pressure Chemical Vapor Déposition). Cette couche 301 permet de passiver et d'isoler électriquement les parties exposées des couches de l'empilement.

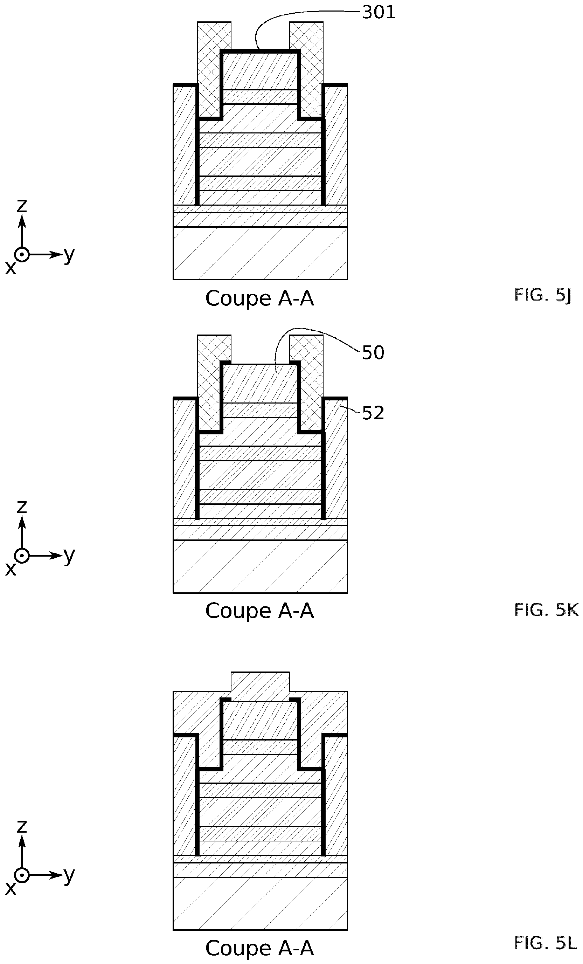

Les figures 5J et 5K illustrent l'ouverture de la couche 301 au niveau des électrodes supérieure 50 et inférieure 52, typiquement par lithographie/gravure.

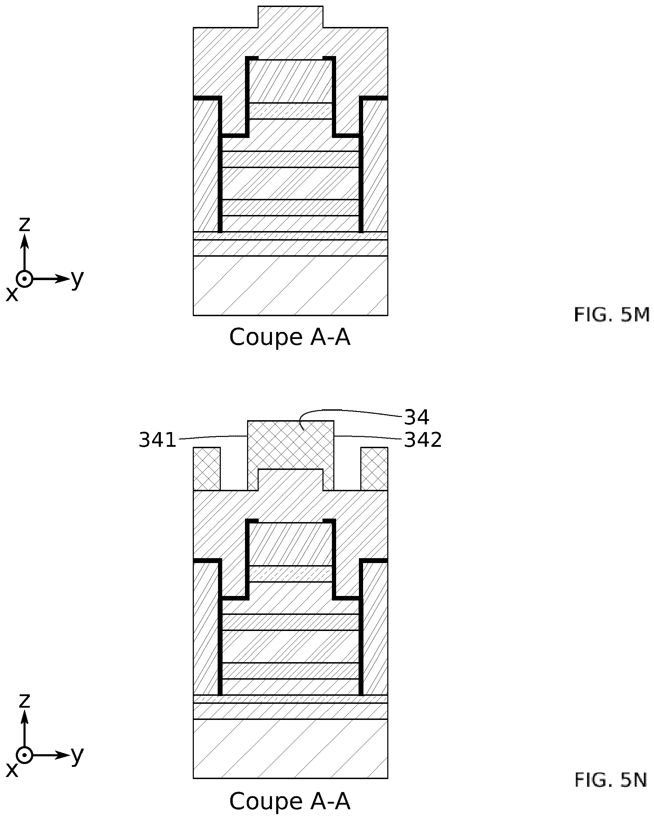

Un premier dépôt métallique peut ensuite être effectué (figure 5L). Ce premier dépôt métallique peut être suivi par un deuxième dépôt métallique, par exemple par dépôt électrochimique (figure 5M). Cela permet d'augmenter la hauteur totale des électrodes métalliques.

La figure 5N illustre la formation d'un masque 34 de lithographie destiné à définir les électrodes supérieure et inférieure « épaissies ». Ce masque 34 pour la gravure de métal épais peut typiquement être à base d'une résine de type TDUR de 5 µm d'épaisseur.

Selon une possibilité, le masque 34 peut présenter des flancs 341, 342 pourvus de corrugations alignées avec les corrugations existantes de l'électrode 50. Cela permet d'augmenter à la fois l'épaisseur de l'électrode supérieure 50 et la hauteur h' des corrugations 56, de façon à ce que les corrugations 56 latérales s'étendent sur toute la hauteur de l'électrode supérieure 50, comme dans le cas illustré en figure 2A.

Selon une autre possibilité, le masque 34 peut présenter des flancs 341, 342 sensiblement plans, dépourvus de corrugations. Cette variante du procédé permet de former le dispositif illustré en figure 2B, comprenant un DFB latéral métallique seulement sur une partie inférieure de l'électrode supérieure 50.

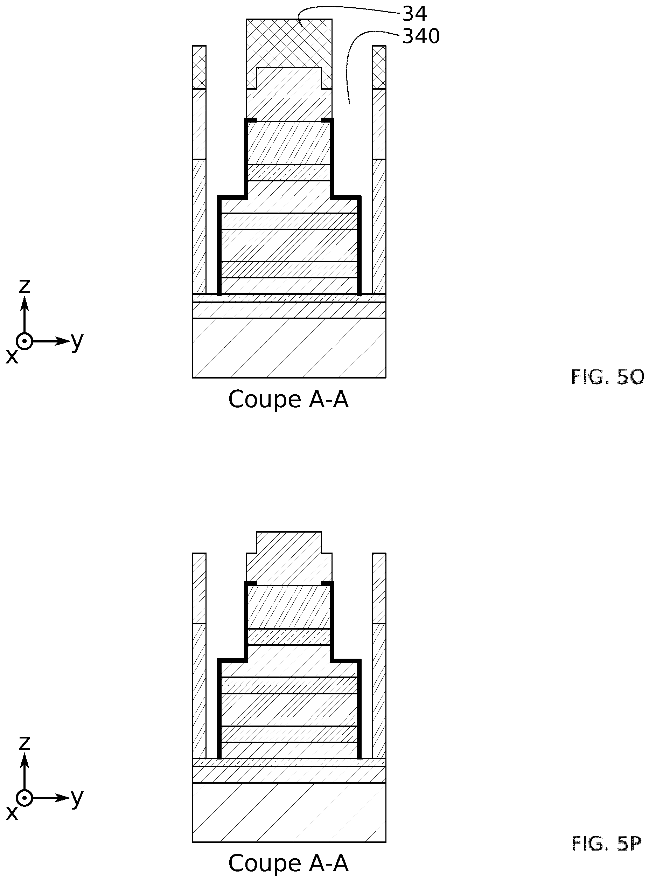

Le métal situé au niveau des ouvertures 340 du masque 34 est ensuite gravé jusqu'à la couche de passivation 301, le long des flancs latéraux 101, 102 de l'empilement 10 (figure 5O). Les électrodes inférieures 52 situées de part et d'autre de l'empilement 10 sont ainsi réalisées. Le masque 34 est ensuite retiré (figure 5P).

Le procédé permet avantageusement de réaliser le laser décrit et illustré précédemment.

L'invention n'est pas limitée aux modes de réalisations précédemment décrits et s'étend à tous les modes de réalisation couverts par les revendications.

Les lasers LCQ DFB réalisés par ce procédé peuvent notamment présenter d'autres architectures, par exemple selon une configuration dite à double tranchée, ou selon une configuration permettant de contacter deux lasers avec une électrode commune.

## Revendications

1. Laser comprenant un miroir de Bragg distribué,
ledit laser étant destiné à émettre un rayonnement lumineux selon une direction longitudinale (x) et comprenant un guide d'onde (100) formé au moins en partie dans un empilement (10) de couches (11, 11 bis, 12, 13, 14, 15, 16) à base de matériaux III-V comprenant au moins une région active (13) configurée pour émettre ledit rayonnement lumineux,
ledit miroir comprenant des corrugations (56) latérales distribuées périodiquement selon la direction longitudinale (x) selon une période Λ, lesdites corrugations latérales étant portées par au moins un plan latéral (xz) défini par la direction longitudinale (x) et une première direction transverse (z) normale à la direction longitudinale (x), lesdites corrugations latérales présentant une dimension d selon une deuxième direction transverse (y) normale à la direction longitudinale (x),
ledit laser comprenant en outre une électrode supérieure (50) disposée sur le guide d'onde (100), selon la première direction transverse (z),
les corrugations (56) latérales du miroir de Bragg étant situées au moins en partie au niveau de flancs latéraux (501, 502) de l'électrode supérieure (50), lesdits flancs latéraux (501, 502) s'étendant parallèlement au plan latéral (xz), ledit laser étant **caractérisé en ce que** lesdites corrugations latérales (56) du miroir de Bragg s'étendent uniquement sur lesdits flancs latéraux (501, 502) de l'électrode supérieure (50).

2. Laser selon la revendication 1 dans lequel le guide d'onde (100) comprend une couche supérieure (16) à base d'InGaAs présentant une concentration de dopants supérieure ou égale à 1 × 10¹⁹cm⁻³.

3. Laser selon l'une quelconque des revendications précédentes dans lequel le guide d'onde (100) présente une hauteur h inférieure ou égale à 6 µm.

4. Laser selon l'une quelconque des revendications précédentes dans lequel la période Λ et la dimension d sont choisies telles que 0,2 ≤ d/Λ ≤ 2.

5. Procédé de formation d'un laser comprenant un miroir de Bragg distribué, comprenant :
- Une fourniture d'un empilement (10) de couches (11, 11 bis, 12, 13, 14, 15, 16) à base de matériaux III-V comprenant au moins une région active (13) destinée à émettre un rayonnement lumineux,
- Une formation d'un motif de guide d'onde (100) dans l'empilement (10) de couches, ledit motif de guide d'onde (100) présentant une longueur L selon une direction longitudinale (x), une hauteur h selon une première direction transverse (z) et une largeur w selon une deuxième direction transverse (y), les première et deuxième directions transverses (z, y) étant normales à la direction longitudinale (x),
- Un premier dépôt d'une première couche métallique (400) sur un sommet du motif de guide d'onde (100),
- Une structuration de ladite première couche métallique de sorte à former une électrode supérieure (50) présentant des flancs latéraux (501, 502) s'étendant parallèlement à un plan latéral (xz) défini par la direction longitudinale (x) et la première direction transverse (z),
ladite structuration étant configurée pour former des corrugations latérales (56) au niveau desdits flancs latéraux (501, 502) de l'électrode supérieure (50), lesdites corrugations latérales étant périodiques de période Λ selon la direction longitudinale (x) et présentant une dimension d selon la deuxième direction transverse (y), de sorte que ladite électrode supérieure (50) forme au moins en partie le miroir de Bragg distribué, lesdites corrugations latérales (56) du miroir de Bragg s'étendant uniquement sur lesdits flancs latéraux (501, 502) de l'électrode supérieure (50).

6. Procédé selon la revendication précédente dans lequel la structuration de la première couche métallique est effectuée par gravure anisotrope selon la première direction transverse (z), ladite gravure anisotrope étant configurée pour s'arrêter sur le sommet du motif de guide d'onde (100), de sorte que les corrugations latérales (56) du miroir de Bragg s'étendent sur toute une hauteur h₅₀ de l'électrode supérieure (50).

7. Procédé selon l'une quelconque des revendications 5 à 6 comprenant en outre, après structuration de la première couche métallique (400), un deuxième dépôt d'une deuxième couche métallique sur l'électrode supérieure.

8. Procédé selon la revendication précédente dans lequel le deuxième dépôt est réalisé par dépôt électrochimique.

9. Procédé selon la revendication précédente comprenant en outre une structuration complémentaire de la deuxième couche métallique, de façon à former un motif d'électrode complémentaire sur l'électrode supérieure.

10. Procédé selon la revendication précédente dans lequel ladite structuration complémentaire est configurée de sorte à prolonger les corrugations latérales de l'électrode supérieure sur des flancs latéraux du motif d'électrode complémentaire.

11. Procédé selon la revendication 9 dans lequel ladite structuration complémentaire est configurée de sorte à ce que le motif d'électrode complémentaire présente des flancs latéraux parallèles au plan latéral (xz) et exempts de corrugations latérales.

## Patentansprüche

1. Laser, der einen verteilten Bragg-Spiegel umfasst,
wobei der Laser bestimmt ist, um eine Lichtstrahlung in einer Längsrichtung (x) zu emittieren, und einen Wellenleiter (100) umfassend, der mindestens teilweise in einem Stapel (10) von Schichten (11, 11 bis, 12, 13, 14, 15, 16) gebildet ist, basierend auf III-V-Materialien, die mindestens einen aktiven Bereich (13) umfassen, der konfiguriert ist, um die Lichtstrahlung zu emittieren,
wobei der Spiegel seitliche Wellungen (56) umfasst, die periodisch verteilt sind in der Längsrichtung (x) gemäß einer Periode Λ, wobei die seitlichen Wellungen durch mindestens eine seitliche Ebene (xz) getragen werden, die durch die Längsrichtung (x) definiert ist, und eine erste Querrichtung (z), die senkrecht zur Längsrichtung (x) ist, wobei die seitlichen Wellungen eine Dimension d in einer zweiten Querrichtung (y) aufweisen, die senkrecht zur Längsrichtung (x) ist,
wobei der Laser ferner eine obere Elektrode (50) umfasst, die auf dem Wellenleiter (100) angeordnet ist, in der ersten Querrichtung (z),
wobei sich die seitlichen Wellungen (56) des Bragg-Spiegels mindestens teilweise an den seitlichen Flanken (501, 502) der oberen Elektrode (50) befinden, wobei sich die seitlichen Flanken (501, 502) parallel zur seitlichen Ebene (xz) erstrecken, wobei der Laser **dadurch gekennzeichnet ist , dass** sich die seitlichen Wellungen (56) des Bragg-Spiegels nur an den seitlichen Flanken (501, 502) der oberen Elektrode (50) erstrecken.

2. Laser nach Anspruch 1, wobei der Wellenleiter (100) eine obere Schicht (16) umfasst, die auf InGaAs basiert, und eine Dotierstoffkonzentration größer oder gleich 1 × 10¹⁹cm⁻³ aufweist.

3. Laser nach einem der vorhergehenden Ansprüche, wobei der Wellenleiter (100) eine Höhe h von 6 µm oder weniger aufweist.

4. Laser nach einem der vorhergehenden Ansprüche, wobei die Periode Λ und die Dimension d als 0,2 ≤ d/Λ ≤ 2 gewählt sind.

5. Verfahren zum Bilden eines Lasers, der einen verteilten Bragg-Spiegel umfasst, umfassend:
- eine Bereitstellung eines Stapels (10) von Schichten (11, 11bis, 12, 13, 14, 15, 16) auf III-V-Materialien basierend, die mindestens einen aktiven Bereich (13) umfassen, der dazu bestimmt ist, Lichtstrahlung zu emittieren,
- eine Bildung eines Wellenleitermusters (100) im Stapel (10) der Schichten, wobei das Wellenleitermuster (100) eine Länge L in einer Längsrichtung (x) aufweist, eine Höhe h in einer ersten Querrichtung (z) und eine Breite w in einer zweiten Querrichtung (y), wobei die erste und die zweite Querrichtung (z, y) senkrecht zur Längsrichtung (x) sind,
- eine erste Abscheidung einer ersten Metallschicht (400) auf einem Scheitelpunkt des Wellenleitermusters (100),
- eine Strukturierung der ersten Metallschicht, um eine obere Elektrode (50) zu bilden, die seitliche Flanken (501, 502) aufweist, die sich parallel zu einer seitlichen Ebene (xz) erstrecken, die durch die Längsrichtung (x) und die erste Querrichtung (z) definiert ist,
wobei die Strukturierung konfiguriert ist, um seitliche Wellungen (56) auf dem Niveau der seitlichen Flanken (501, 502) der oberen Elektrode (50) zu bilden, wobei die seitlichen Wellungen periodisch mit der Periode Λ in der Längsrichtung (x) sind, und eine Dimension d in der zweiten Querrichtung (y) aufweisen, so dass die obere Elektrode (50) mindestens teilweise den verteilten Bragg-Spiegel bildet, wobei sich die seitlichen Wellungen (56) des Bragg-Spiegels nur über die seitlichen Flanken (501, 502) der oberen Elektrode (50) erstrecken.

6. Verfahren nach dem vorhergehenden Anspruch, wobei die Strukturierung der ersten Metallschicht durch anisotropes Ätzen in der ersten Querrichtung (z) erfolgt, wobei das anisotrope Ätzen konfiguriert ist, um am Scheitelpunkt des Wellenleitermusters (100) zu stoppen, so dass sich die seitlichen Wellungen (56) des Bragg-Spiegels über eine ganze Höhe hso der oberen Elektrode (50) erstrecken.

7. Verfahren nach einem der Ansprüche 5 bis 6, ferner umfassend, nach der Strukturierung der ersten Metallschicht (400), eine zweite Abscheidung einer zweiten Metallschicht auf der oberen Elektrode.

8. Verfahren nach dem vorhergehenden Anspruch, wobei die zweite Abscheidung durch elektrochemische Abscheidung realisiert wird.

9. Verfahren nach dem vorhergehenden Anspruch, ferner eine komplementäre Strukturierung der zweiten Metallschicht umfassend, um ein komplementäres Elektrodenmuster auf der oberen Elektrode zu bilden.

10. Verfahren nach dem vorhergehenden Anspruch, wobei die komplementäre Strukturierung konfiguriert ist, um die seitlichen Wellungen der oberen Elektrode an den seitlichen Flanken des komplementären Elektrodenmusters zu verlängern.

11. Verfahren nach Anspruch 9, wobei die komplementäre Strukturierung so konfiguriert ist, dass das komplementäre Elektrodenmuster seitliche Flanken aufweist, die parallel zur seitlichen Ebene (xz) und ohne seitliche Wellungen sind.

## Claims

1. A laser comprising a distributed Bragg mirror,
said laser being designed to emit a light radiation along a longitudinal direction (x) and comprising a waveguide (100) formed at least partly in a stack (10) of layers (11, 11bis, 12, 13, 14, 15, 16) made of III-V materials comprising at least one active region (13) configured to emit said light radiation,
said mirror comprising lateral corrugations (56) distributed periodically along a longitudinal direction (x) in a period Λ, said lateral corrugations being carried by at least a lateral plane (xz) defined by the longitudinal direction (x) and a first transverse direction (z) normal to the longitudinal direction (x), said lateral corrugations having a dimension d along a second transverse direction (y) normal to the longitudinal direction (x),
said laser further comprising a top electrode (50) arranged on the waveguide (100), along the first transverse direction (z),
the lateral corrugations (56) of the Brag mirror being located at least partly at the level of the lateral flanks (501, 502) of the top electrode (50), said lateral flanks (501, 502) extending parallel to the lateral plane (xz), said laser being **characterised in that** said lateral corrugations (56) of the Bragg mirror are extending only on said lateral flanks (501, 502) of the top electrode (50).

2. The laser according to claim 1, wherein the waveguide (100) comprises an InGaAs-based top layer (16) with a dopant concentration greater than or equal to 1 × 10¹⁹cm⁻³.

3. The laser according to any one of the preceding claims wherein the waveguide (100) has a height h less than or equal to 6 µm.

4. The laser according to any one of the preceding claims wherein the period Λ and the dimension d are chosen such that 0.2 ≤ d/Λ ≤ 2.

5. A method for forming a laser comprising a distributed Bragg mirror, comprising:
- Providing a stack (10) of layers (11, 11bis, 12, 13, 14, 15, 16) made of III-V materials comprising at least one active region (13) designed to emit a light radiation,
- Forming a waveguide (100) pattern in the stack (10) of layers, said waveguide (100) pattern having a length L along a longitudinal direction (x), a height h along a first transverse direction (z) and a width w along a second transverse direction (y), the first and second transverse directions (z, y) being normal to the longitudinal direction (x),
- A first deposition of a first metal layer (400) on a top of the waveguide (100) pattern,
- Structuring said first metal layer so as to form a top electrode (50) having lateral flanks (501, 502) extending parallel to a lateral plane (xz) defined by the longitudinal direction (x) and the first transverse direction (z).
said structuring being configured to form lateral corrugations (56) at the level of said lateral flanks (501, 502) of the top electrode (50), said lateral corrugations being periodic with period Λ along the longitudinal direction (x) and having a dimension d along the second transverse direction (y), such that the said top electrode (50) at least partly forms the distributed Bragg mirror, said lateral corrugations (56) of the Bragg mirror extending only on said lateral flanks (501, 502) of the top electrode (50).

6. The method according to the preceding claim wherein the structuring of the first metal layer is performed by anisotropic etching along the first transverse direction (z), said anisotropic etching being configured to stop on the top of the waveguide (100) pattern (100), such that the lateral corrugations (56) of the Bragg mirror extend along a whole height hso of the top electrode (50).

7. The method according to any one of claims 5 to 6 further comprising, after structuring the first metal layer (400), a second deposition of a second metal layer on the top electrode.

8. The method according to the preceding claim wherein the second deposition is performed by electrochemical deposition.

9. The method according to the preceding claim further comprising a complementary structuring of the second metal layer, so as to form a complementary electrode pattern on the top electrode.

10. The method according to the preceding claim wherein said complementary structuring is configured so as to extend the lateral corrugations of the top electrode on the lateral flanks of the complementary electrode pattern.

11. The method according to claim 9 wherein said complementary structuring is configured such that the complementary electrode pattern has lateral flanks parallel to the lateral plane (xz) and free of any lateral corrugations.
